# EUROPÄISCHE PATENTANMELDUNG

(11) **EP 4 016 609 A1**
(43) Veröffentlichungstag der Anmeldung: **22.06.2022**
(21) Anmeldenummer: 20214055.4
(22) Anmeldetag: 15.12.2020
(51) Int. Cl.: H01L 23/373, H01L 23/42

(54) **VORRICHTUNG MIT BAUELEMENT UND ANGEKOPPELTEM KÜHLKÖRPER**

(71) Anmelder: Siemens Aktiengesellschaft, 80333 München (DE)
(72) Erfinder: Heimann, Matthias, 14469 Potsdam (DE); Müller, Bernd, 16259 Falkenberg (DE); Pfeifer, Markus, 90455 Nürnberg (DE); Strogies, Jörg, 14163 Berlin (DE); Wilke, Klaus, 12527 Berlin (DE)

(57) **Zusammenfassung**

Es wird ein Vorrichtung (1) angegeben mit
- einem Bauelement (100),
- einem Kühlkörper (200) und
- einem Verbindungselement (300), welches zwischen dem Bauelement (100) und dem Kühlkörper (200) angeordnet ist und den Kühlkörper (200) thermisch an das Bauelement (100) anbindet,
- wobei das Verbindungselement (300) einen porigen Verbindungskörper (310) umfasst,
- wobei die Poren (311) des Verbindungskörpers (310) zumindest teilweise mit einem Füllstoff (320) gefüllt sind.

Weiterhin wird ein Verfahren zur Herstellung einer solchen Vorrichtung (1) angegeben.

## Beschreibung

Die vorliegende Erfindung betrifft eine Vorrichtung mit einem Bauelement, einem Kühlkörper und einem Verbindungselement, durch welches das Bauelement thermisch an den Kühlkörper angebunden ist. Weiterhin betrifft die Erfindung ein Verfahren zur Herstellung einer solchen Vorrichtung.

Nach dem Stand der Technik werden vor allem leistungselektronische Module sehr häufig mit Kühlkörpern verbunden, um die bei den immer höher werdenden Verlustleistungsdichten nötige Entwärmung sicherzustellen und eine Überhitzung der Module zuverlässig zu vermeiden. Um dies zu erreichen, sind die entsprechenden Kühlkörper meist sehr dicht bei den Leistungsmodulen angeordnet und es wird versucht, bei der thermischen Anbindung des Kühlkörpers an das Modul einen möglichst niedrigen thermischen Widerstand zu erzielen. Neben dieser guten thermischen Anbindung sind im Bereich der Verbindungsstelle häufig noch weitere Anforderungen zu erfüllen. Darunter fällt beispielsweise eine hohe Beständigkeit der mechanischen und thermischen Eigenschaften der Verbindung unter den Betriebsbedingungen, inklusive der im Betrieb auftretenden Temperaturänderungen. Weiterhin müssen von der Gesamt-Vorrichtung oft enge geometrische Toleranzen eingehalten werden, und die Herstellung soll insgesamt möglichst kostengünstig erfolgen können.

Zur Lösung dieses Problems haben sich im Stand der Technik zwei unterschiedliche Ansätze durchgesetzt: Beim ersten gängigen Lösungsansatz wird zwischen dem zu entwärmenden Bauteil und dem Kühlkörper eine Lötverbindung hergestellt. Es handelt sich dabei also um eine dauerhafte Verbindung mit dem Nachteil, dass sie sich für den Austausch eines der Elemente nicht so einfach wieder lösen lässt. Weiterhin kann die Einhaltung der übergeordneten geometrischen Toleranzen hier schwierig sein, da die fertigungsbedingten Abweichungen in den Abmessungen von Kühlkörper und Leistungsmodul nur sehr schwer durch kontrollierte Anpassungen in der Geometrie der Lotschicht ausgeglichen werden können. Schließlich ist eine solche Lötverbindung nach ihrer Herstellung starr, so dass beim Betrieb der Vorrichtung kein nachträglicher Ausgleich von eventuell vorliegenden geometrischen Abweichungen von einem Soll-Maß mehr vorgenommen werden kann.

Beim zweiten gängigen Lösungsansatz wird der Kühlkörper mittels einer Wärmeleitpaste an das zu entwärmende Bauteil angekoppelt. Hier wird also eine wieder lösbare Verbindung geschaffen, und die Verbindung wird dadurch aufrechterhalten, dass Kühlkörper und Bauteil sowohl bei der Montage als auch im Betrieb gegeneinander angepresst werden. Eine solche Anpressung kann durch ein im Stand der Technik grundsätzlich bekanntes Niederhaltesystem realisiert werden, bei welchem beispielsweise über eine Feder oder eine Klammerung ein Anpressdruck erzeugt wird. Ein Nachteil dieser Art der Anbindung ist, dass der thermische Widerstand im Vergleich zur Lötverbindung meist höher ist. Ein weiterer Nachteil liegt darin, dass die Beständigkeit der Verbindung bei den im Betrieb auftretenden hohen Temperaturen und insbesondere den möglichen starken Temperatur-Schwankungen häufig nicht sehr hoch ist. So kann bei längerem Betrieb sowohl der thermische Widerstand als auch die mechanische Beständigkeit einer solchen Verbindung leiden. Weiterhin ist es auch mit einer Wärmeleitpaste schwierig, vorliegende Fertigungstoleranzen der zu verbindenden Teile in definierter Weise auszugleichen. Sie erlaubt zwar eine gewisse Flexibilität bei der Anbindung, aber durch die hohe Verformbarkeit des Kopplungsmediums sind der präzisen Einstellung einer Ziel-Schichtdicke in der Praxis trotzdem Grenzen gesetzt.

Aufgabe der Erfindung ist es daher, eine Vorrichtung mit einem Bauelement und einem daran angekoppelten Kühlkörper anzugeben, welche die genannten Nachteile überwindet. Insbesondere soll eine Vorrichtung zur Verfügung gestellt werden, welche einen vergleichsweise niedrigen Wärmewiderstand für die Ankopplung aufweist und gleichzeitig einen flexiblen Ausgleich von Fertigungstoleranzen durch eine geometrische Anpassung der Verbindungsschicht ermöglicht. Weiterhin soll die Ankopplung trotzdem relativ einfach und kostengünstig zu realisieren sein und während des Betriebs möglichst beständig sein. Eine weitere Aufgabe ist es, ein Verfahren zur Herstellung einer solchen Vorrichtung anzugeben.

Diese Aufgaben werden durch die in Anspruch 1 beschriebene Vorrichtung und das in Anspruch 13 beschriebene Verfahren gelöst. Die erfindungsgemäße Vorrichtung umfasst ein Bauelement, einen Kühlkörper und ein Verbindungselement, welches zwischen dem Bauelement und dem Kühlkörper angeordnet ist und den Kühlkörper thermisch an das Bauelement anbindet. Das Verbindungselement umfasst einen porigen Verbindungskörper, wobei die Poren des Verbindungskörpers zumindest teilweise mit einem Füllstoff gefüllt sind.

Die wesentliche Funktion des Verbindungselements ist also die thermische Ankopplung des Kühlkörpers an das Bauelement, um beim Betrieb der Vorrichtung eine effektive Entwärmung der im Bauelement freigesetzten Verlustwärme zu gewährleisten. Das Verbindungselement dient dazu, einen möglichst niedrigen Wärmewiderstand zwischen Bauelement und Kühlkörper zu schaffen, damit insgesamt ein effektiver Wärmeübergang vom Bauelement als Ort der Verlustleistung zum Kühlkörper als eigentlicher Wärmesenke der Vorrichtung gewährleistet ist. Vom Kühlkörper aus wird die Wärmeenergie an die Umgebung der Vorrichtung abgegeben, nämlich entweder an umgebende Luft oder auch an ein anderes umgebendes Medium wie Kühlwasser oder Kühlöl oder ein anderes flüssiges oder gasförmiges Medium. Vorzugsweise ist das Verbindungselement dabei der wesentliche Wärmepfad zwischen dem Bauelement und dem Kühlkörper. Falls also mehrere parallele Wärmepfade zwischen diesen beiden Elementen vorliegen, dann soll über das Verbindungselement derjenige mit dem kleinsten thermischen Widerstand ausgebildet sein.

Ein wesentlicher Vorteil der erfindungsgemäßen Vorrichtung liegt darin, dass durch den porigen Verbindungskörper ein festes Element in dieser thermischen Verbindung gegeben ist, durch welchen definierte geometrische Eigenschaften und insbesondere ein vordefinierter Abstand eingestellt werden können. Im Gegensatz zu der Verbindung mit Wärmepasten oder zumindest im Montagezustand flüssigen Loten ist liegt hier also ein festes Gerüst innerhalb der Verbindung vor. Abhängig von den genauen Abmessungen dieses Gerüsts können so auch Schwankungen in der exakten Größe und Einbaulage der zu verbindenden Elemente ausgeglichen werden. Auf diese Weise kann der Verbindungskörper dazu beitragen, die geforderten geometrischen Gesamt-Toleranzen der Vorrichtung einzuhalten. Durch die porige Ausgestaltung dieses festen Verbindungskörpers wird dabei gleichzeitig eine gewisse mechanische Flexibilität erreicht, so dass auch bei einer gegebenen Ursprungs-Form und Ursprungs-Größe dieses Verbindungskörpers noch eine Feinabstimmung der tatsächlich in der Einbausituation vorliegenden Abmaße erfolgen kann. Insbesondere kann durch Einwirken einer Anpresskraft auf den Verbindungskörper eine Kompression der porigen Struktur bewirkt werden, so dass abhängig von der gewählten Kraft eine Erreichung einer vordefinierten Zieldicke ermöglicht wird. Abhängig von den Schwankungen in den Größen und Einbaulagen der anderen Bauteile kann dieser Zieldicke in einer Serie von herzustellenden Vorrichtungen für jede einzelne Vorrichtung leicht unterschiedlich gewählt sein, um einen Ausgleich dieser Schwankungen zu schaffen. Es wird also mit anderen Worten ein geometrisch variables Gerüst im Verbindungsbereich geschaffen.

Die beschriebenen mechanischen und geometrischen Vorteile des porigen Verbindungskörpers gehen allerdings mit einem gravierenden Nachteil einher, falls keine weiteren Maßnahmen ergriffen werden: Durch das Vorliegen von Poren in diesem Körper wird die thermische Anbindung zwischen Bauelement und Kühlkörper geschwächt. Dies gilt zumindest dann, wenn die Innenräume der Poren offen bleiben und auf diese Weise kaum zum thermischen Pfad beitragen (oder genauer gesagt: wenn sie mit Luft befüllt sind und durch die niedrige Wärmeleitfähigkeit der Luft einen sehr geringen Beitrag zur Ankopplung leisten). Im Rahmen der vorliegenden Erfindung wird dieses Problem dadurch gelöst, dass die Poren zumindest teilweise mit einem Füllstoff gefüllt sind. Bei diesem Füllstoff soll es sich insbesondere um einen festen oder flüssigen Füllstoff handeln oder auch um einen Stoff, welcher beim Betrieb der Vorrichtung zwischen einem flüssigen und einem festen Zustand wechseln kann. Der Füllstoff ist also jedenfalls nicht gasförmig. Durch diese Füllung wird erreicht, dass der Luftanteil in den Poren verdrängt wird und die effektive Wärmeleitfähigkeit des Verbindungselements im Vergleich zum ungefüllten Verbindungskörper wesentlich verbessert wird. Der Grad dieser Verbesserung ist vom Füllgrad des Füllstoffs abhängig und kann in Abhängigkeit von den benötigten thermischen Eigenschaften eingestellt werden. Auf diese Weise ist mit dem Füllstoff in den Poren ein sehr flexibles "Tuning" zwischen den erwünschten geometrisch-mechanischen und den erwünschten thermischen Eigenschaften des Verbindungselements möglich.

Das erfindungsgemäße Verfahren dient zur Herstellung der erfindungsgemäßen Vorrichtung. Es umfasst die folgenden Schritte :
a) Anbindung des porigen Verbindungskörpers an das Bauelement,
b) Füllen des porigen Verbindungskörpers mit dem Füllstoff,
c) Anbindung des Kühlkörpers an den Verbindungskörper.

Durch dieses Verfahren wird eine vergleichsweise einfache und kostengünstige Möglichkeit geschaffen, eine Vorrichtung mit den weiter beschriebenen Vorteilen herzustellen. Dabei soll die Reihenfolge der Schritte nicht auf die angegebene Reihenfolge beschränkt sein. Vielmehr ergibt sich hier eine Variationsbreite für die Wahl der Reihenfolge, innerhalb der für die konkreten Randbedingungen das einfachste Herstellungsverfahren gewählt werden kann. Wesentlich ist nur, dass damit insgesamt ein gefüllter Verbindungskörper geschaffen wird, welcher thermisch an die beiden zu koppelnden Elemente angebunden wird, um so die oben beschriebenen Vorteile zu erreichen.

Vorteilhafte Ausgestaltungen und Weiterbildungen der Erfindung gehen aus den von den Ansprüchen 1 und 13 abhängigen Ansprüchen sowie der folgenden Beschreibung hervor. Dabei können die beschriebenen Ausgestaltungen der Vorrichtung und des Herstellungsverfahrens allgemein vorteilhaft miteinander kombiniert werden.

So kann das Bauteil insbesondere ein leistungselektronisches Modul oder ein leistungselektronisches Bauteil sein. Die Vorteile der Erfindung kommen dann besonders wirksam zum Tragen, da Verlustleistungsdichten im Bereich der Leistungselektronik allgemein besonders hoch sind und mit steigender Leistung immer mehr ansteigen, so dass hier die Ausbildung eines möglichst effizienten Entwärmungspfades besonders wichtig ist. Ein leistungselektronisches Bauteil kann beispielsweise einen Leistungstransistor umfassen, insbesondere einen IGBT.

Allgemein und unabhängig von der Art und Leistungsklasse des Bauelements kann dieses entweder ein einzelnes Bauteil oder ein Modul darstellen. Dabei soll unter einem Modul insbesondere eine kompakte Schaltungseinheit aus mehreren einzelnen Bauteilen verstanden werden. Ein solches Modul enthält oft auch einen Verdrahtungsträger (insbesondere eine Platine), über den die Anbindung an den Kühlkörper realisiert werden kann. Die thermische Anbindung kann aber prinzipiell auch in einem Modul direkt an das Bauteil erfolgen. Die grundlegende Zielsetzung bei der thermischen Anbindung an einen Kühlkörper ist jedenfalls unabhängig davon, ob es sich bei dem Bauelement um ein Modul oder um ein Einzel-Bauteil handelt.

Allgemein vorteilhaft kann der Kühlkörper eine oberflächenvergrößernde Strukturierung aufweisen, beispielsweise in Form von Rippen, Lamellen oder auch in Form eines Kühlsterns oder verästelter Kühlstrukturen. Auf diese Weise kann der Kühlkörper die Abgabe von Wärme an das umgebende Medium besonders effektiv bewirken. Ein solcher Kühlkörper kann insbesondere im Wesentlichen aus einem metallischen Material gebildet sein oder ein solches Material zumindest als Hauptbestandteil umfassen. Ein Vorteil eines solchen metallischen Kühlkörpers ist die vergleichsweise hohe Wärmeleitfähigkeit von Metallen. Besonders bevorzugt sind in diesem Zusammenhang Aluminium, Kupfer oder eine auf zumindest einem dieser Metalle basierende Legierung. Alternativ können hier aber auch andere Materialien mit hoher Wärmeleitfähigkeit zum Einsatz kommen, beispielsweise Keramiken wie Aluminiumoxid oder Aluminiumnitrid oder Verbundwerkstoffe, welche insbesondere wiederum ein metallisches Material als Komponente aufweisen können. Optional kann der Kühlkörper auch mit einer funktionalen Schicht beschichtet sein. So kann beispielsweise ein aluminium-basierter Kühlkörper mit einer Nickel-Schicht beschichtet sein, um eine Inertisierung zu erzielen, insbesondere auch gegenüber reaktiven Materialen, welche als Füllstoff des Verbindungskörpers zum Einsatz kommen können.

Der porige Verbindungskörper kann vorteilhaft aus einem metallischen Material gebildet sein. Ein solches metallisches Gerüstmaterial hat einerseits den Vorteil, dass durch die hohe Wärmeleitfähigkeit von Metallen schon ein guter Wärmetransport über das Porengerüst stattfinden kann. Ein weiterer Vorteil besteht darin, dass metallische Porengerüste relativ gut zerstörungsfrei verformt werden können, da sie nicht sehr spröde sind. Auf diese Weise kann mit einem solchen flexiblen Gerüstmaterial die weiter oben angesprochene geometrische Anpassungsmöglichkeit realisiert werden. Besonders geeignet ist hierfür wiederum Kupfer oder eine kupferbasierte Legierung. Ähnlich wie beim Kühlkörper kann auch bei dem Gerüstmaterial des Verbindungskörpers eine funktionelle Beschichtung sinnvoll sein, insbesondere mit einem vergleichsweise inerten Material, welche eine Reaktion des Verbindungskörpers mit dem darin eingefüllten Füllstoff verhindert. Dies kann auch hier beispielsweise eine nickelbasierte Beschichtung sein.

Alternativ kann als Gerüstmaterial des Verbindungskörpers grundsätzlich auch ein nicht-metallisches Material zum Einsatz kommen, beispielsweise ein Kunststoff und insbesondere ein Polymer. Dadurch, dass der Füllstoff, insbesondere bei hohen Füllgraden, einen wesentlichen Anteil des Wärmetransports übernimmt, kann für das Porengerüst des Verbindungskörpers auch ein Material mit einer vergleichsweise niedrigen Wärmeleitfähigkeit gewählt werden. Durch die Wirkung des Füllstoffes kann trotzdem eine vergleichsweise hohe (effektive) Gesamt-Wärmeleitfähigkeit über das Verbindungselement erreicht werden.

Allgemein und unabhängig von der genauen Materialwahl ist es vorteilhaft, wenn der Verbindungskörper so ausgestaltet ist, dass er zerstörungsfrei verformbar ist. So kann insbesondere abhängig von der Einwirkung einer Druckkraft eine Dickenänderung des Verbindungselements und damit eine Änderung des Abstands zwischen Bauelement und Kühlkörper bewirkt werden. Prinzipiell kann es sich dabei entweder mehr um eine elastische Verformbarkeit oder auch mehr um eine plastische Verformbarkeit handeln. Bei der plastischen Verformung kann mittels einer Druckkraft eine dauerhafte geometrische Änderung bewirkt werden. Bei der elastischen Verformung ergibt sich dagegen eine Rückstellkraft, welche der Anpresskraft entgegenwirkt und auf diese Weise eine variable, kraftabhängige geometrische Anpassung ermöglicht. Um eine optimale geometrische Anpassung zu erreichen, kann auch ein Wechselspiel zwischen plastischer und elastischer Verformung wünschenswert sein.

Gemäß einer vorteilhaften Ausführungsform kann der porige Verbindungskörper im Wesentlichen offenporig sein. Bei einem solchen ofenporigen Körper sind die Hohlräume der einzelnen Poren über Durchlässe sowohl miteinander als auch mit der äußeren Umgebung verbunden, so dass sich ein Netzwerk von Hohlräumen und damit eine übergeordnete Porosität ergibt. Dies bewirkt, dass der porige Verbindungskörper nachträglich (also nach der Fertigstellung der porösen Struktur) mit einem Füllstoff befüllt werden kann. So kann die Ausbildung des Gerüsts und die Füllung mit dem Füllstoff in zwei getrennten Schritten erfolgen, was die Herstellung insgesamt vereinfacht. Alternativ ist es aber auch grundsätzlich möglich, dass die Füllung mit dem Füllstoff bereits während der Ausbildung der porigen Struktur erfolgt. Bei dieser Variante kann dann auch ein geschlossenporiger Verbindungskörper zum Einsatz kommen. Es sind auch Mischformen denkbar, bei denen die Hohlräume teilweise geschlossen und teilweise miteinander verbunden sind.

Vorteilhaft liegt der Volumen-Füllfaktor des porigen Verbindungskörpers in einem Bereich zwischen 15 % und 70 %. Unter diesem Volumen-Füllfaktor soll der Volumenanteil des Verbindungselements verstanden werden, der durch das Gerüstmaterial und nicht durch die Hohlräume der Poren gegeben ist. Wenn dieser Volumen-Füllfaktor sehr niedrig ist, ist die mechanische Stabilität der Gerüststruktur gefährdet. Wenn er dagegen sehr hoch ist, dann ist die Verformbarkeit gering. Im genannten bevorzugten Bereich kann mit dem Verbindungskörper sowohl eine grundlegende mechanische Stabilität als auch eine hinreichende Verformbarkeit erreicht werden.

Der Füllstoff des porigen Verbindungskörpers kann vorteilhaft ein metallisches Material aufweisen. Dies kann insbesondere eine niedrigschmelzende Legierung wie beispielsweise ein Lotmaterial oder ein Flüssigmetall sein. Alternativ kann der Füllstoff aber auch eine fluorierte organische Flüssigkeit umfassen. Dies kann beispielsweise ein Perfluortributylamin sein. Solche Flüssigkeiten werden von dem Unternehmen 3M unter dem Handelsnamen "Fluorinert" vertrieben. Ein Beispiel ist "Fluorinert FC-43", welches im Stand der Technik insbesondere als Kühlmittel eingesetzt wird.

Allgemein vorteilhaft ist der Füllstoff zumindest während der Montage der Vorrichtung flüssig, so dass über eine Verformung des zu befüllenden oder gerade gefüllten Verbindungskörpers eine geometrische Anpassung möglich ist. Während des Betriebs der Vorrichtung kann der Füllstoff dann je nach Betriebstemperatur und Schmelzbereich entweder fest oder flüssig sein oder auch einen gelegentlichen Phasenwechsel zwischen diesen beiden Aggregatzuständen durchlaufen.

Allgemein und unabhängig von der genauen Wahl von Material und Schmelzbereich ist vorteilhaft, wenn der Füllstoff eine Wärmeleitfähigkeit von wenigstens 10 W/m·K aufweist.

Mit einem solchen thermisch gut leitfähigen Füllstoff kann durch die Verdrängung der Luft aus den Poren insgesamt eine gute Wärmeankopplung über das Verbindungselement erreicht werden. Selbst wenn das Material des porigen Gerüsts nicht sehr gut wärmeleitend ist, so kann abhängig vom Füllgrad trotzdem insgesamt noch eine mäßige bis gute effektive Gesamt-Wärmeleitfähigkeit erzielt werden. Insgesamt ergibt sich also eine Art Parallelschaltung zwischen dem Wärmepfad des Gerüsts und dem Wärmepfad des Füllstoffes. Durch die genaue Wahl der Materialien und des Füllgrads kann die effektive Gesamt-Leitfähigkeit sehr gezielt eingestellt werden, wobei gleichzeitig die sonstigen, insbesondere mechanisch-geometrischen Anforderungen ebenfalls berücksichtigt werden. So kann in einer vorteilhaften Ausgestaltung beispielsweise eine effektive Gesamt-Wärmeleitfähigkeit des Verbindungselements von 10 W/m·K oder mehr erreicht werden.

Allgemein kann der Füllgrad (also der Anteil, zu welchem das Porenvolumen mit dem Füllmittel befüllt ist) vorteilhaft zwischen 25% und 80% liegen. Prinzipiell könnte der Füllgrad auch noch niedriger liegen und sogar nur wenige Prozent betragen, doch wird dann der Beitrag des Füllstoffes zur Wärmeleitung relativ gering. Anderseits kann der Füllgrad auch noch bis zu 90% oder bis zu 95% oder sogar noch höher liegen, was den Beitrag zur Wärmeleitung entsprechend weiter erhöht. Allerdings ist eine vollständige Ausfüllung des porigen Gerüsts in der Praxis oft schwierig, da erstens nicht immer alle Poren nach außen hin offen sind und zweitens die Benetzung des Füllstoffs auf dem Material des Verbindungskörpers nicht immer optimal sein wird.

Wie bereits erwähnt, ergeben sich für den Aggregatzustand des Füllstoffes mehrere Möglichkeiten. Gemäß einer ersten vorteilhaften Ausführungsvariante kann der Füllstoff während der Montage (insbesondere während der Befüllung des Verbindungskörpers) flüssig sein, aber während des Betriebs der Vorrichtung fest sein. Sein Schmelzpunkt ist dann so gewählt, dass er oberhalb der maximal auftretenden Betriebstemperatur liegt.

So kann bei dieser ersten Ausführungsvariante der Schmelzpunkt bzw. der Schmelzbereich des Füllstoffes allgemein oberhalb von 200 °C und insbesondere zwischen 200 °C und 300 °C liegen. Bei dem Füllstoff kann es sich also insbesondere um eine entsprechende Lotlegierung handeln. Typische Montage-Temperaturen, bei denen ein solches Lot als Füllstoff in den Verbindungskörper eingefüllt werden kann, liegen beispielsweise im Bereich zwischen etwa 230°C und 260°C. Der vorgegebene Temperaturbereich für den Betrieb der Vorrichtung kann gewählt sein, dass die maximale Betriebstemperatur einen Wert von 200 °C nicht überschreitet. Bei typischen Leistungsmodulen können die maximalen Betriebstemperaturen beispielsweise in einem Bereich zwischen etwa 150 °C und etwa 200 °C liegen.

Geeignete Lotlegierungen können hier beispielsweise Zinn-basierte Lote sein, insbesondere Zinn-Silber-Kupfer-Lote (abgekürzt SAC, mit z.B. etwa 3% Silber-Anteil und etwa 0,5 % Kupferanteil und einem Schmelzbereich zwischen 217 °C und 219°C) oder Zinn-Antimon-Lote (mit z.B. etwa 95% Zinn und etwa 5% Antimon und einem Schmelzbereich zwischen 232 °C und 240 °C).

Ein wesentlicher Vorteil dieser ersten Ausführungsvariante ist, dass durch den dauerhaft festen Füllstoff auch beim Betrieb der Vorrichtung eine hohe Stabilität gegeben ist. So ergeben sich während des Betriebs auch keine Probleme mit eventuellen Veränderungen des Füllgrades oder der Kapselung des Verbindungselements. Allerdings ist das Verbindungselement beim Betrieb auch weniger leicht verformbar als bei den flüssigen Füllstoffen. Daher ist eine geometrische Anpassung hier hauptsächlich auf den Montageschritt beschränkt. Dies kann aber durchaus ausreichen, um Schwankungen in Größe und Einbaulage der zu verbindenden Elemente ausgleichen zu können. Im Zusammenhang mit dieser Ausführungsvariante kann es vorteilhaft sein, wenn der Füllstoff mit dem Material des Verbindungskörpers im Kontaktbereich reagiert und dort eine Diffusionsfügeverbindung eingeht. Auf diese Weise kann aus den beiden Materialien ein übergeordneter Festkörper mit vergleichsweise homogenen Eigenschaften gebildet werden. Bei den anderen beiden Varianten mit (zumindest teilweise) flüssigem Füllstoff ist eine solche Reaktion dagegen eher nachteilig und sollte durch eine entsprechende Materialwahl oder eine Inertisierung der Oberfläche des Verbindungskörpers nach Möglichkeit vermieden werden.

Gemäß einer zweiten vorteilhaften Ausführungsvariante kann der Füllstoff während der Montage flüssig sein, und während des Betriebs der Vorrichtung zwischen einem flüssigen und einem festen Zustand wechseln. Sein Schmelzpunkt ist dann so gewählt, dass er unterhalb der maximal auftretenden Betriebstemperatur, aber oberhalb der minimal auftretenden Betriebstemperatur liegt.

So kann bei dieser zweiten Ausführungsvariante der Schmelzpunkt bzw. der Schmelzbereich des Füllstoffes allgemein zwischen 100 °C und 200 °C liegen. Bei dem Füllstoff kann es sich also insbesondere um eine entsprechende Niedertemperatur-Lotlegierung handeln.

Geeignete Lotlegierungen können hier beispielsweise Zinn-Bismut-basierte Lote sein (z.B. Sn43Bi58 mit einem Schmelzpunkt bei 138°C) oder Indium-Zinn-basierte Lote (z.B. mit Schmelzbereichen zwischen etwa 118 °C und 131 °C) oder Zinn-Antimon-basierte Lote (z.B. mit einem Schmelzpunkt von etwa 139°C). Bei dieser zweite Ausführungsvariante können also ebenfalls noch vergleichsweise gebräuchliche Lotmaterialien zum Einsatz kommen. Aufgrund des gelegentlich im Betrieb vorkommenden Übergangs in den flüssigen Aggregatzustand kann auch im Betriebszustand eine geometrische Anpassung des Verbindungselements erfolgen.

Gemäß einer dritten Ausführungsvariante kann der Füllstoff während der Montage flüssig sein, und auch während des Betriebs der Vorrichtung (zumindest typischerweise) flüssig sein. Sein Schmelzpunkt ist dann so gewählt, dass er unterhalb (typischen) minimal auftretenden Betriebstemperatur liegt.

So kann bei dieser dritten Ausführungsvariante der Schmelzpunkt bzw. der Schmelzbereich des Füllstoffes allgemein unterhalb 100 °C liegen. Bei dem Füllstoff kann es sich also insbesondere um ein Flüssigmetall oder um eine andere Art von Kühlflüssigkeit handeln, beispielsweise eine fluorierte organische Flüssigkeit und insbesondere ein Fluorinert.

Ein Flüssigmetall kann beispielsweise vorteilhaft Gallium, Indium, Zinn und/oder Quecksilber umfassen. Derartige Metalle sind vorteilhafte Komponenten, um in einer metallischen Legierung einen niedrigen Schmelzpunkt zu erreichen. Besonders vorteilhaft weist das Flüssigmetall sowohl Gallium als auch Indium und Zinn auf. Gemäß einer besonders bevorzugten Ausführungsform besteht sie sogar ausschließlich aus den drei genannten Metallen. Beispielsweise kann es sich bei der Flüssigkeit um eine Legierung handeln, die in der Fachwelt unter dem Namen Galinstan bekannt ist. Galinstan ist eine eutektische Legierung, welche etwa 68,5 Gewichtsprozent Gallium sowie etwa 21,5 Gewichtsprozent Indium und etwa 10 Gewichtsprozent Zinn aufweist. Eine solche Legierung weist einen sehr niedrigen Schmelzpunkt von etwa -19 °C auf. Andere geeignete niedrigschmelzende Legierungen sind beispielsweise unter den Namen Indalloy 51 und Indalloy 60 von der US-amerikanischen Firma Indium Corporation in Utica, NY erhältlich. Weitere geeignete galliumbasierte Legierungen sind beispielsweise diejenigen Legierungen, die in den Patentschriften US5800060B1 und US7726972B1 beschrieben sind. Sie können neben den drei genannten besonders bevorzugten Metallen auch Zusätze von anderen Metallen wie beispielsweise Zink (insbesondere zwischen etwa 2 und 10 Gewichtsprozent) umfassen.

Die beschriebenen Legierungen, welche auf Gallium, Indium und/oder Zinn basieren, haben den Vorteil, dass sie eine geringe Toxizität aufweisen und somit relativ unbedenklich bezüglich Gesundheits- und Umweltschädigungen sind. Quecksilber ist ebenfalls ein geeignetes Flüssigmetall oder ein geeigneter Legierungsbestandteil für niedrigschmelzende Legierungen, hat aber den grundsätzlichen Nachteil, dass es stark toxisch ist.

Allgemein und unabhängig von ihrer genauen Zusammensetzung kann die metallische Flüssigkeit eine eutektische Legierung sein. Eine derartige Legierung ist besonders bevorzugt, da mit ihr ein wesentlich niedrigerer Schmelzpunkt erreicht werden kann als mit ihren einzelnen metallischen Komponenten.

Flüssigmetalle haben mit den weiter oben beschriebenen Lotlegierungen den Vorteil gemeinsam, dass sie vergleichsweise gut wärmeleitend sind. Um Unterschied dazu sind nicht-metallische Flüssigkeiten typischerweise wesentlich schwächer wärmeleitend. Allerdings kann in solchen nicht-metallischen Flüssigkeiten der Beitrag der Konvektion zum Gesamt-Wärmetransport deutlich höher sein, so dass solche Materialien - und insbesondere die genannten Fluorinerts - trotzdem grundsätzlich als Füllstoffe in Frage kommen können.

Eine grundlegende Schwierigkeit bei der zweiten und dritten Ausführungsvariante ist, dass durch den (zumindest teilweise) flüssigen Füllstoff eine zuverlässige Kapselung des porösen Verbindungskörpers nach außen hin benötigt wird. Zweckmäßigerweise wird der Verbindungskörper daher (entweder vor oder nach dem Füllvorgang) von einer geeigneten Kapselung bzw. Umhüllung umgeben. Weiterhin kann insbesondere bei der zweiten und dritten Ausführungsvariante eine Ausgleichseinrichtung vorgesehen sein, mit welcher eine Volumenänderung eines im Verbindungskörper enthaltenen und beim Betrieb der Vorrichtung flüssigen Füllstoffs ausgeglichen werden kann. So kann beispielsweise ein Ausgleichsreservoir vorgesehen sein, welches fluidisch mit dem Füllstoff innerhalb des Verbindungskörpers verbunden ist. Nach dem Prinzip der kommunizierenden Röhren können so Änderungen in der vom Verbindungskörper aufgenommenen Menge an flüssigem Füllstoff ausgeglichen werden. Es kann auch eine variable Anpassung der Dicke des Verbindungselements (und somit des Abstands zwischen Kühlkörper und Bauelement) vorgesehen sein, um z.B. temperaturbedingten Änderungen in der Aufnahmefähigkeit des Verbindungskörpers entgegenzuwirken. Eine solche Höhenanpassung kann beispielsweis kraftgesteuert sein, wobei insbesondere eine auf den Kühlkörper einwirkende Anpresskraft variiert werden kann.

Es ist aber auch der Fall denkbar, dass auch bei der zweiten und dritten Ausführungsvariante auf eine externe Ausgleichseinrichtung für den Füllstoff verzichtet werden kann. Dies ist insbesondere dann der Fall, wenn die Poren im Ausgangszustand nicht vollständig gefüllt sind, so dass bei einer Kompression des Porengerüsts der Füllgrad automatisch erhöht wird. Mit anderen Worten ist hier ein Ausgleichsmechanismus für das Füllvolumen bereits in das unvollständig befüllte Porengerüst integriert. Bei dieser Variante ist daher auch eine vollständige flüssigkeitsdichte Kapselung des Verbindungselements gegen die äußere Umgebung möglich.

Wie bereits weiter oben erwähnt, ist die Reihenfolge der beschriebenen Verfahrensschritte a), b) und c) grundsätzlich beliebig, so dass sich hier mehrere mögliche Varianten für die Prozessreihenfolge ergeben. So kann bei einer möglichen Ausführungsform des Verfahrens der Schritt b), also das Füllen des porigen Verbindungskörpers mit dem Füllstoff, separat und insbesondere vor den anderen Schritten erfolgen, so dass ein vorkonfektioniertes gefülltes Bauteil gebildet wird.

Dadurch kann die Anbindung der Teilelemente in den Schritten a) und c) ähnlich wie beim Stand der Technik gehandhabt werden, was die Herstellung deutlich vereinfacht. Alternativ kann der Füllschritt b) aber auch "in situ" erfolgen, also mit anderen Worten in engem Zusammenhang mit der Ausbildung der Ankopplung. Beispielsweise kann er nach Schritt a), aber vor Schritt c) erfolgen. Mit anderen Worten erfolgt dann die Befüllung, nachdem der Verbindungskörper schon an das Bauelement angebunden wurde, aber bevor der Kühlkörper montiert wird. Gemäß einer weiteren Alternative ist es aber auch möglich, dass Schritte a) und c) vorab durchgeführt werden, also die Verbindung von Bauelement und Kühlkörper über das Verbindungselement schon geschaffen wird und die Füllung gemäß Schritt b) erst ganz am Schluss erfolgt, beispielsweise durch Infiltration des Verbindungskörpers von der Seite.

Grundsätzlich können sowohl die Anbindung des Verbindungskörpers an das Bauelement gemäß Schritt a) als auch die Anbindung des Kühlkörpers an den Verbindungskörpers gemäß Schritt c) reversibel erfolgen. Es ist dann also keine dauerhafte (insbesondere keine stoffschlüssige) Verbindung vorgesehen, sondern es reicht aus, wenn die einzelnen Elemente durch eine Anpresskraft miteinander verbunden werden. Bei dieser Variante ist das Verbindungselement ein sogenannter "Einleger", also eine lose eingelegte Zwischenlage, welche vorteilhaft zerstörungsfrei demontiert werden kann, um Änderungen an der Vorrichtung vorzunehmen. Allgemein und unabhängig davon, ob zwischen den einzelnen Elementen ein fester Verbund geschaffen wird oder nicht, kann das Verbindungselement vorteilhaft flach und mattenartig ausgebildet sein und dabei insbesondere eine einheitliche Dicke aufweisen.

Alternativ zu dem vorab geschriebenen lose übereinandergelegten Stapel ist es aber prinzipiell auch möglich, dass in Schritt a) und/oder in Schritt c) ein fester, stoffschlüssiger Verbund beschaffen wird. Dies kann insbesondere dann der Fall sein, wenn in Schritt a) der Verbindungskörper durch additive Fertigung auf das Bauelement aufgebracht wird. Diese Ausführungsform kann besonders vorteilhaft sein, um einen porösen Körper mit fest definierten und unter Umständen auch geometrisch komplexen Poren-Eigenschaften herzustellen. Alternativ zu diesem Aufbringen "in situ" durch additive Fertigung kann der porige Verbindungskörper aber auch vorab, z.B. als vorkonfektioniertes Bauteil additiv gefertigt sein. Allgemein eröffnet die additive Fertigung des Verbindungskörpers Möglichkeiten der Formgebung, die bei klassischen Herstellungsverfahren entweder gar nicht oder weniger genau oder zumindest weniger einfach zu erreichen sind.

Gemäß einer besonders bevorzugten Ausgestaltung kann durch additive Fertigung des Verbindungskörpers ein Gradient in einer seiner geometrischen Eigenschaften erzeugt werden. Dies kann insbesondere ein Gradient über die Schichtdicke (also in Richtung des Abstands zwischen Bauelement und Kühlkörper) sein. Beispielsweise kann durch gezielte Variation der additiven Fertigungsparameter ein Gradient beim Porenanteil (also beim offenen Volumen), bei der Porengröße und/oder beim Vernetzungsgrad der Poren geschaffen werden.

Nachfolgend wird die Erfindung anhand einiger bevorzugter Ausführungsbeispiele unter Bezugnahme auf die angehängten Zeichnungen beschrieben, in denen:
- Figur 1: einen schematischen Querschnitt einer Vorrichtung nach einem ersten Beispiel der Erfindung zeigt und
- Figuren 2 bis 4: verschiedene Stadien der Herstellung einer beispielhaften Vorrichtung zeigen.

In den Figuren sind gleiche oder funktionsgleiche Elemente mit gleichen Bezugszeichen versehen.

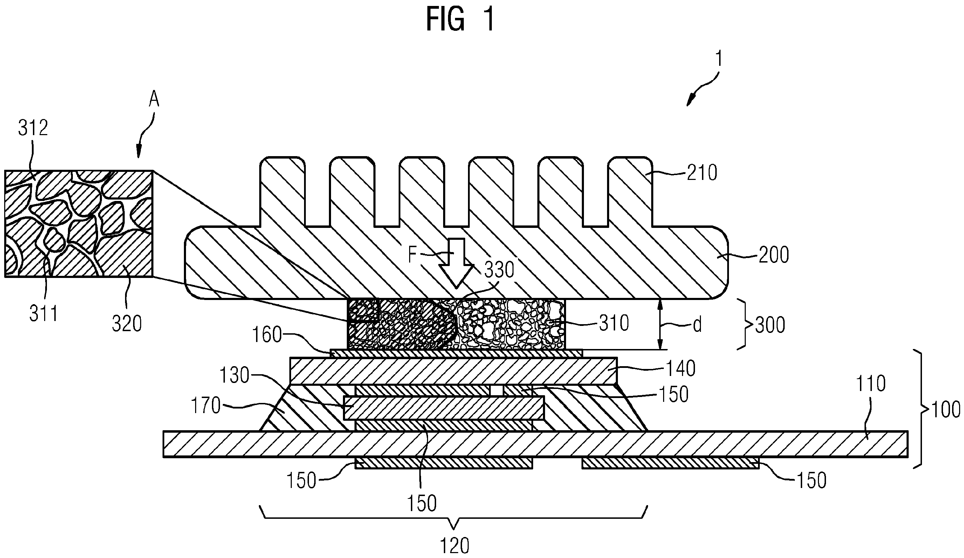

In Figur 1 ist ein schematischer Querschnitt einer Vorrichtung 1 nach einem ersten Ausführungsbeispiel der Erfindung gezeigt. Diese Vorrichtung 1 enthält ein Bauelement 100, welches über ein Verbindungselement 300 thermisch an einen Kühlkörper 200 gekoppelt ist. Über diesen thermischen Pfad wird eine Abfuhr der beim Betrieb des Bauelements 100 freigesetzten Verlustwärme bewirkt. Das Bauelement ist in diesem Beispiel ein Modul, das ein leistungselektronisches Bauteil 130 enthält. In diesem leistungselektronischen Bauteil 130 wird der größte Teil der Verlustwärme des Moduls freigesetzt, weshalb die thermische Anbindung an den Kühlkörper 200 auch in räumlicher Nähe zum Bauteil 130 realisiert ist. Das Modul umfasst jedoch noch weitere Elemente, unter anderem einen Hauptverdrahtungsträger 110, der optional auch noch weitere hier nicht dargestellte elektronische Bauteile tragen kann. Auf der dem Hauptverdrahtungsträger 110 abgewandten Seite des leistungselektronischen Bauteils 130 ist hier ein weiterer Verdrahtungsträger 140 angeordnet, welcher dem einzelnen Bauteil 130 zugeordnet ist. Die beiden Verdrahtungsträger 110 und 140 sind mit dem Bauteil 130 sowie mit weiteren hier nicht explizit dargestellten Elementen elektrisch über Metallisierungsschichten 150 verbunden. Über weitere, untenliegende Metallisierungen 150 ist der Hauptverdrahtungsträger 110 mit einem äußeren Stromkreis oder weiteren elektrischen bzw. elektronischen Vorrichtungen verbindbar. Der Bereich der leistungselektronischen Funktionseinheit 120 ist zur Kapselung gegenüber der äußeren Umgebung mit einem Vergussharz 170 vergossen.

Die thermische Ankopplung der leistungselektronischen Funktionseinheit 120 an den Kühlkörper 200 ist durch ein flaches, mattenartiges Verbindungselement 300 realisiert. Dieses ist über eine Metallisierungsschicht 160 thermisch an den Verdrahtungsträger 140 angebunden. Diese Anordnung ist jedoch nur beispielhaft zu verstehen, und die Anbindung könnte prinzipiell auch in anderen Bereichen des Moduls erfolgen. Insbesondere könnte auch ein einzelnes (leistungs-)elektronisches Bauteil 130 direkt an das Verbindungselement 300 angebunden sein, also ohne dazwischengeschalteten Verdrahtungsträger 140. Das Verbindungselement 300 kann lose eingelegt sein oder auch mit dem Bauelement 100 bzw. dem Kühlkörper 200 dauerhaft verbunden sein.

Das Verbindungselement 300 weist einen Verbindungskörper 310 auf, welcher als poriges Gerüst ausgebildet ist, wie in der Ausschnittsvergrößerung A erkennbar. Das Material dieses Porengerüsts 312 kann beispielsweise ein metallisches Material sein. In der Ausschnittsvergrößerung ist nur beispielhaft eine Ausführung mit einem vergleichsweise geringen Volumenfüllfaktor des Gerüstmaterials und einem entsprechend hohen Volumenanteil der Poren 311 gezeigt. Dies ist jedoch nur exemplarisch zu verstehen, und der Volumenfüllfaktor des Gerüsts kann in der Praxis über einen breiten Wertebereich variieren, in Abhängigkeit von den thermischen und mechanisch-geometrischen Anforderungen. Im gezeigten Beispiel ist der porige Verbindungskörper 310 offenporig, d.h. die einzelnen Poren 311 sind zumindest zum großen Teil über Durchgänge zu einem übergeordneten Netzwerk miteinander verbunden.

Die Figur 1 zeigt beispielhaft einen Zustand, in dem die Poren 311 des Verbindungskörpers 310 nur im linken Teil der Zeichnung mit einem Füllstoff 320 befüllt sind. So ist im Bereich der Ausschnittvergrößerung A ein wesentlicher Teil der offenen Poren 311 durch den Füllstoff 320 ausgefüllt. Im rechten Teil der Figur ist der Verbindungskörper 310 jedoch noch nicht mit dem Füllstoff 320 infiltriert. Es kann sich hier beispielsweise um ein Prozessstadium handeln, bei dem der Verbindungskörper 310 gerade mit dem flüssigen Füllstoff 320 infiltriert wird, so dass sich im mittleren Bereich eine Flüssigkeitsfront 330 ergibt. Zumindest bei diesem Prozessschritt, also während der Infiltration des porigen Körpers, ist der Füllstoff 320 ein flüssiges Material. Später, beim Betrieb der Vorrichtung, kann der Füllstoff 320 flüssig oder fest sein oder zwischen diesen beiden Aggregatzuständen wechseln. Nur beispielhaft ist im Ausschnitt A ein Zustand gezeigt, bei dem die Poren 311 im Wesentlichen vollständig gefüllt sind. In der Praxis kann auch nur ein wesentlich kleinerer Füllgrad erreicht werden, insbesondere wenn ein Teil der Poren sehr klein ist und die Benetzungseigenschaften für eine vollständige Füllung nicht ausreichend sind.

In jedem Fall wird durch die zumindest anteilige Füllung der Poren 311 mit dem Füllstoff 320 erreicht, dass Luft aus den Poren 311 verdrängt wird und durch ein Material mit höherer Wärmeleitfähigkeit (im Vergleich zur Luft) ersetzt wird. Somit wird die Wärmeleitfähigkeit des Verbindungskörpers 310 im Vergleich zum ungefüllten Zustand erhöht. Auf diese Weise wird die thermische Anbindung an den Kühlkörper 200 wesentlich verbessert. Beim Beispiel der Figur 1 weist der Kühlkörper 200 eine Mehrzahl von Kühlrippen 210 auf, um die Abgabe von Wärme von dem Kühlkörper an die Umgebung zu fördern. Um die Anbindung des Kühlkörpers 200 an das Verbindungselement 300 sicherzustellen, wird der Kühlkörper 200 mit einer Anpresskraft F auf das Verbindungselement 310 und damit indirekt auch die übrigen Teile der leistungselektronischen Funktionseinheit 120 gepresst. Diese Anpressung wird beispielsweise über ein hier nicht näher dargestelltes Niederhaltesystem erreicht. Abhängig von der gewählten Anpresskraft F kann das Verbindungselement 300 unterschiedlich stark komprimiert werden. Insbesondere führt die porige Ausgestaltung des Verbindungskörpers zu einer mechanischen Verformbarkeit, so dass die Dicke d des Verbindungskörpers abhängig von der Kraft F variiert werden kann. Auf diese Weise kann die Dicke d gezielt eingestellt werden, und es können fertigungsbedingte Schwankungen in der Größe und Einbaulage der zu verbindenden Elemente 100 und 200 ausgeglichen werden. Diese Verformbarkeit des Verbindungskörpers 310 ist auch im gefüllten Zustand gegeben, zumindest solange der Füllstoff 320 in einem flüssigen Aggregatzustand ist. Damit ist zumindest während der Montage eine Möglichkeit der geometrischen Anpassung gegeben. Wenn der Füllstoff einen so niedrigen Schmelzpunkt aufweist, dass er auch beim Betrieb der Vorrichtung (teilweise) flüssig ist, dann ist auch hierbei die Möglichkeit der geometrischen Anpassung weiterhin gegeben.

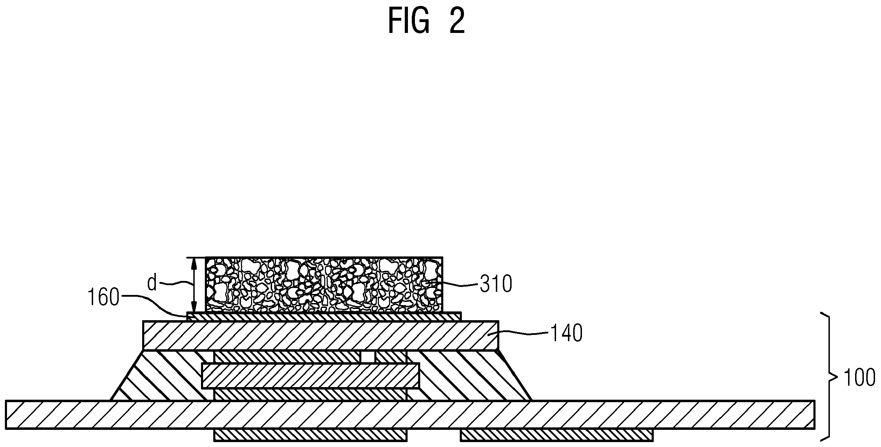

In den Figuren 2 bis 4 sind verschiedene Stadien bei der Herstellung einer Vorrichtung 1 nach einem weiteren Ausführungsbeispiel der Erfindung gezeigt. Dabei ist die fertige Vorrichtung insgesamt sehr ähnlich wie beim Beispiel der Figur 1 ausgebildet. Figur 2 zeigt ein Prozessstadium, bei dem der Verbindungsköper 310 des Verbindungselements bereits auf dem Bauelement 100 aufgebracht ist, aber noch nicht mit dem Füllstoff befüllt ist. Der Verbindungskörper 310 kann auch hier nach Art eines Einlegers lose aufgelegt sein. Besonders bevorzugt ist er aber durch additive Fertigung "in situ" auf dem Bauelement 100 erzeugt worden. Hierdurch ist der Verbindungskörper 310 beispielsweise mit der Metallisierungsschicht 160 des Verdrahtungsträgers 140 dauerhaft verbunden. Diese dauerhafte Anbindung kann jedoch auch an anderer Stelle erfolgen, insbesondere auf dem (leistungselektronischen) Bauteil 130 selbst. Durch die additive Fertigung kann beispielsweise ein Gradient bestimmter Eigenschaften des Porengerüsts in Richtung der Dicke d erzeugt werden. Alternativ kann jedoch auch ein Gradient in einer anderen Raumrichtung erzeugt werden, oder es können verschiedene Gradienten bezüglich verschiedener Eigenschaften überlagert sein. Bei der variierten Eigenschaft kann es sich insbesondere um eine geometrische Eigenschaft wie beispielsweise die Porengröße, den geometrischen Füllfaktor des Porengerüsts und/oder den Vernetzungsgrad der Poren handeln. Es kann sich aber auch um einen Gradienten in der Materialzusammensetzung des Porengerüsts handeln.

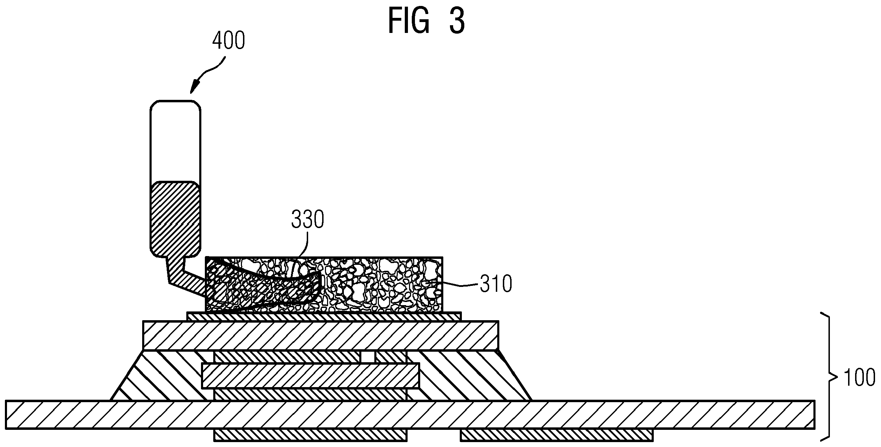

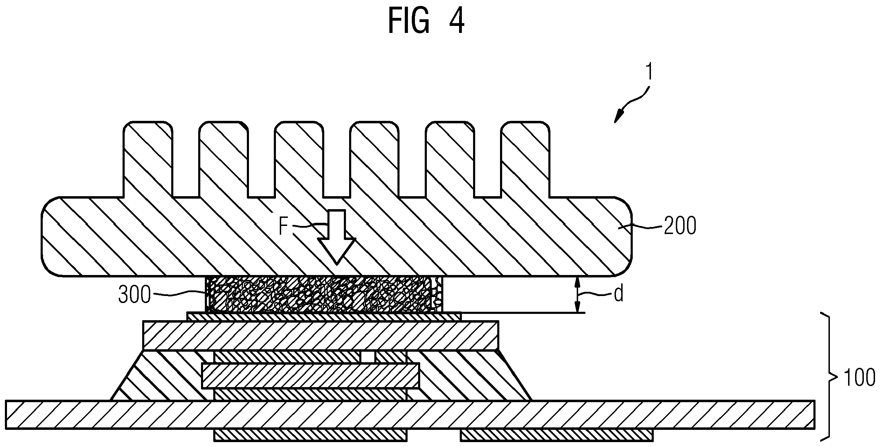

Figur 3 zeigt ein anschließendes Prozessstadium, bei dem der fertige Verbindungskörper 310 "in situ" mit dem Füllstoff 320 befüllt wird. Hierzu ist eine nur schematisch dargestellte Dosiereinrichtung 400 mit dem Verbindungskörper 310 verbunden. Dies kann, wie hier gezeigt, an der Seite des Verbindungskörpers erfolgen oder auch prinzipiell von der noch offenliegenden Oberseite aus. Auch hier ist eine Flüssigkeitsfront 330 zu erkennen, da der Verbindungskörper 310 erst teilweise mit dem Füllstoff befüllt ist. Im Unterschied zum Beispiel der Figur 1 wird hier also die Befüllung vor der Anbindung des Kühlkörpers vorgenommen. Figur 4 zeigt einen darauffolgenden Zustand der Vorrichtung 1, bei dem der Kühlkörper 200 an das inzwischen fertig befüllte Verbindungselement 300 angebunden ist. Ähnlich wie beim Beispiel der Figur 1 wird der Kühlkörper mit einer Anpresskraft F auf das Verbindungselement 300 gedrückt. Durch die mechanische Flexibilität wird das mattenartige Verbindungselement 300 aufgrund der Anpresskraft F zusammengedrückt, so dass seine Dicke d im Vergleich zu den Figuren 2 und 3 reduziert ist. Auf diese Weise kann kraftabhängig eine gewünschte Dicke eingestellt werden, zumindest solange der Füllstoff noch flüssig ist. Dieser Dickenunterschied ist jedoch stark übertrieben dargestellt. So kann insbesondere die Andruckkraft relativ klein ausgestaltet sein, insbesondere wenn nur geringe geometrische Anpassungen nötig sind. Da die Benetzung des Kühlkörpers 200 durch den flüssigen Füllstoff mit zur Anbindung des Kühlkörpers beitragen kann, kann diese Anpresskraft vorteilhaft geringer gewählt werden als beim Stand der Technik.

Falls der Füllstoff auch während des Betriebs der Vorrichtung (zumindest teilweise) im flüssigen Zustand verbleibt, kann es vorteilhaft sein, das Verbindungselement zumindest im Bereich der umlaufenden seitlichen Begrenzungsfläche gegen die äußere Umgebung zu kapseln. Eine solche Verkapselung kann das Verbindungselement auch vollständig umhüllen, so dass dieses im fertigen Zustand keinen flüssigen Füllstoff mehr an die Umgebung abgeben kann. Alternativ zu dieser vollständigen Kapselung kann aber auch eine externe Ausgleichseinrichtung vorgesehen sein, welche insbesondere bei einer starken Kompression des Verbindungselements den austretenden Füllstoff aufnehmen und bei einer Dekompression wieder abgeben kann. Dazu kann beispielsweise ein Ausgleichsbehälter vorgesehen sein, welcher analog zur Dosiervorrichtung in der Figur 3 (allerdings im fertig aufgebauten Zustand, also an der Vorrichtung inklusive Kühlkörper) im seitlichen Bereich des Verbindungselements fluidisch mit dem Innenraum des Porengerüsts verbunden ist.

### Bezugszeichenliste

- 1: Vorrichtung
- 100: Bauelement
- 110: Hauptverdrahtungsträger
- 120: leistungselektronische Funktionseinheit
- 130: leistungselektronisches Bauteil
- 140: Verdrahtungsträger der leistungselektronischen Einheit
- 150: Metallisierungsschichten
- 160: Metallisierungsschicht
- 170: Vergussharz
- 200: Kühlkörper
- 210: Kühlrippe
- 300: Verbindungselement
- 310: Verbindungskörper
- 311: Pore
- 312: Porengerüst
- 320: Füllstoff
- 330: Flüssigkeitsfront
- 400: Dosiereinrichtung
- A: Ausschnittsvergrößerung
- d: Dicke des Verbindungselements
- F: Anpresskraft

## Patentansprüche

1. Vorrichtung (1) mit
- einem Bauelement (100),
- einem Kühlkörper (200) und
- einem Verbindungselement (300), welches zwischen dem Bauelement (100) und dem Kühlkörper (200) angeordnet ist und den Kühlkörper (200) thermisch an das Bauelement (100) anbindet,
- wobei das Verbindungselement (300) einen porigen Verbindungskörper (310) umfasst,
- wobei die Poren (311) des Verbindungskörpers (310) zumindest teilweise mit einem Füllstoff (320) gefüllt sind.

2. Vorrichtung (1) nach Anspruch 1, bei welcher das Bauelement (100) ein leistungselektronisches Modul oder ein leistungselektronisches Bauteil (130) ist.

3. Vorrichtung (1) nach einem der Ansprüche 1 oder 2, bei welcher der Kühlkörper (200) eine oberflächenvergrößernde Strukturierung (210) aufweist und insbesondere im Wesentlichen aus einem metallischen Material gebildet ist.

4. Vorrichtung (1) nach einem der vorhergehenden Ansprüche, bei welcher der porige Verbindungskörper (310) aus einem metallischen Material gebildet ist.

5. Vorrichtung (1) nach einem der vorhergehenden Ansprüche, bei welcher der porige Verbindungskörper (310) im Wesentlichen offenporig ist.

6. Vorrichtung (1) nach einem der vorhergehenden Ansprüche, bei welchem der Volumen-Füllfaktor des porigen Verbindungskörpers (310) in einem Bereich zwischen 15 % und 70 % liegt.

7. Vorrichtung (1) nach einem der vorhergehenden Ansprüche, bei welcher der Füllstoff (320) ein metallisches Material, insbesondere eine niedrigschmelzende Legierung, oder eine fluorierte organische Flüssigkeit aufweist.

8. Vorrichtung (1) nach einem der vorhergehenden Ansprüche, bei welcher der Füllstoff (320) eine Wärmeleitfähigkeit von wenigstens 10 W/m·K aufweist.

9. Vorrichtung (1) nach einem der vorhergehenden Ansprüche, bei welcher der Füllstoff (320) einen Schmelzpunkt oberhalb von 200 °C, insbesondere zwischen 200 °C und 300 °C aufweist.

10. Vorrichtung (1) nach einem der Ansprüche 1 bis 8, bei welcher der Füllstoff (320) einen Schmelzpunkt zwischen 100 °C und 200 °C aufweist.

11. Vorrichtung (1) nach einem der Ansprüche 1 bis 8, bei welcher Füllstoff (320) einen Schmelzpunkt unterhalb von 100 °C aufweist.

12. Vorrichtung (1) nach einem der vorhergehenden Ansprüche, insbesondere der Ansprüche 10 oder 11, welche eine Ausgleichseinrichtung aufweist, mit welcher eine Volumenänderung eines im Verbindungskörper (310) enthaltenen und beim Betrieb der Vorrichtung flüssigen Füllstoffs (320) ausgeglichen werden kann.

13. Verfahren zur Herstellung einer Vorrichtung (1) nach einem der vorhergehenden Ansprüche, welches die folgenden Schritte umfasst:
a) Anbindung des porigen Verbindungskörpers (310) an das Bauelement (100),
b) Füllen des porigen Verbindungskörpers (310) mit dem Füllstoff (320),
c) Anbindung des Kühlkörpers (200) an den Verbindungskörper (310).

14. Verfahren nach Anspruch 13, bei welcher in Schritt a) der Verbindungskörper (310) durch additive Fertigung auf das Bauelement (100) aufgebracht wird.

15. Verfahren nach Anspruch 14, bei welchem durch additive Fertigung ein Gradient in einer geometrischen Eigenschaft des Verbindungskörpers erzeugt wird.
